# EUROPEAN PATENT APPLICATION

(11) **EP 4 572 561 A1**
(43) Date of publication of application: **18.06.2025**
(21) Application number: 24193835.6
(22) Date of filing: 09.08.2024
(51) Int. Cl.: H10D 30/66, H10D 30/69, H10D 62/10, H10D 64/68

(54) **POWER SEMICONDUCTOR DEVICES**

(30) Priority: 13.12.2023 KR 20230180411
(71) Applicant: SAMSUNG ELECTRONICS CO., LTD., Yeongtong-gu Suwon-si, Gyeonggi-do 16677 (KR)
(72) Inventor: KO, Mingu, 16677 Suwon-si (KR); KIM, Taehun, 16677 Suwon-si (KR); PARK, Gyeongseon, 16677 Suwon-si (KR); KIM, Youngcheol, 16677 Suwon-si (KR); KIM, Jongseob, 16677 Suwon-si (KR)
(74) Representative: Marks & Clerk LLP

(57) **Abstract**

A power semiconductor device includes a substrate; a drift layer on the substrate; a well region extending from an upper surface of the drift layer into the drift layer; a source region extending from an upper surface of the well region into the well region; a gate electrode on the drift layer and the well region; a gate insulating layer between the gate electrode and the well region; an isolation insulating layer in an isolation trench extending from the upper surface of the drift layer into the drift layer below the gate electrode; a dielectric layer covering the gate electrode and the source region; and a drain electrode on a lower surface of the substrate. At least one of the gate insulating layer, the isolation insulating layer, or the dielectric layer is configured to apply tensile stress to at least a portion of the well region.

## Description

### BACKGROUND

The present disclosure relates to a power semiconductor device, and to a metal oxide semiconductor field effect transistor (MOSFET) power semiconductor device.

Power semiconductor devices may be semiconductor devices that operate in high voltage and high current environments and may be used in fields that require high power switching, such as power conversion, power converters, inverters, or the like. Power semiconductor devices basically require voltage resistance characteristics against high voltages, and recently, additionally require high-speed switching operations. Accordingly, power semiconductor devices using SiC, which has superior voltage resistance characteristics, as compared to silicon (Si), are being researched.

### SUMMARY

An aspect of the present disclosure is to provide a power semiconductor device having improved electrical characteristics.

A power semiconductor device includes a substrate of a first conductivity-type; a drift layer of the first conductivity-type on the substrate; a well region of a second conductivity-type extending from an upper surface of the drift layer into the drift layer; a source region of the first conductivity-type extending from an upper surface of the well region into the well region; a gate electrode on a portion of the drift layer and a portion of the well region; a gate insulating layer between the gate electrode and the well region; an isolation insulating layer in an isolation trench extending from the upper surface of the drift layer into the drift layer below the gate electrode; a dielectric layer covering the gate electrode and a portion of the source region; and a drain electrode on a lower surface of the substrate, wherein at least one of the gate insulating layer, the isolation insulating layer, or the dielectric layer is configured to apply tensile stress to at least a portion of the well region.

A power semiconductor device includes a substrate of a first conductivity-type; a drift layer of the first conductivity-type on the substrate; a well region of a second conductivity-type extending from an upper surface of the drift layer into the drift layer; a source region of the first conductivity-type extending from an upper surface of the well region into the well region; a gate electrode on a portion of the drift layer; an isolation insulating layer on one side of the gate electrode at a depth overlapping at least a portion of the well region; a dielectric layer covering the gate electrode and exposing a portion of the source region; and a drain electrode on a lower surface of the substrate, wherein at least one of the isolation insulating layer or the dielectric layer is configured to apply tensile stress to at least a portion of the well region.

A power semiconductor device includes a substrate of a first conductivity-type; a drift layer of the first conductivity-type on the substrate; a well region of a second conductivity-type extending from an upper surface of the drift layer into the drift layer; a source region of the first conductivity-type extending from an upper surface of the well region into the well region; a gate electrode on a portion of the drift layer; a gate insulating layer below the gate electrode; an isolation layer in an isolation trench extending from the upper surface of the drift layer into the drift layer below the gate electrode; a dielectric layer covering the gate electrode and exposing a portion of the source region; and a drain electrode on a lower surface of the substrate, wherein at least one of the isolation layer or the dielectric layer is configured to apply stress to at least a portion of the well region.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIGS. 1A and 1B are a cross-sectional view and a partially enlarged view illustrating an example power semiconductor device.
FIGS. 2A to 2E are cross-sectional views illustrating example power semiconductor devices.
FIG. 3 is a cross-sectional view illustrating an example power semiconductor device.
FIGS. 4A to 4E are cross-sectional views illustrating example power semiconductor devices.
FIG. 5 is a cross-sectional view illustrating an example power semiconductor device.
FIGS. 6A to 6F are views illustrating a process sequence illustrating an example method of manufacturing a power semiconductor device.
FIGS. 7A to 7C are views illustrating a process sequence illustrating an example method of manufacturing a power semiconductor device.

### DETAILED DESCRIPTION

Hereinafter, implementations of a power semiconductor device will be described with reference to the accompanying drawings. Hereinafter, it can be understood that terms such as 'on,' 'upper,' `upper portion,' `upper surface,' 'below,' 'lower,' `lower portion,' `lower surface,' `side surface,' and the like may be denoted by reference numerals and refer to the drawings, except where otherwise indicated. Relative terms, such as "above", "below", etc. are relative to the structure of the semiconductor device (e.g. based on a vertical axis defined perpendicular to a substrate of the semiconductor device) and therefore do not imply any particular orientation of the semiconductor device in use. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of a plurality of elements forming the semiconductor device. Accordingly, where the structure of a single element of a plurality of elements has been described, this structure may equally apply to other elements of the plurality of elements.

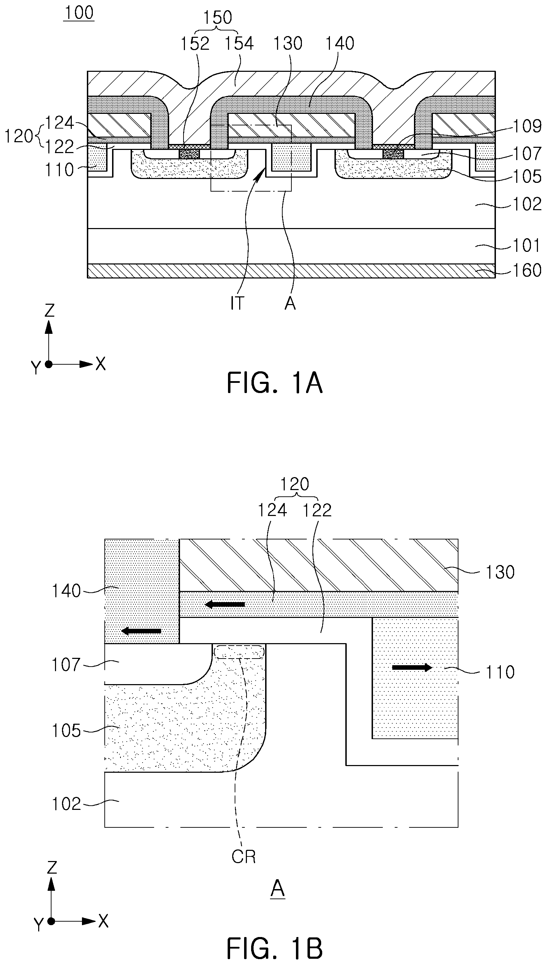

FIGS. 1A and 1B are a cross-sectional view and a partially enlarged view illustrating an example power semiconductor device. FIG. 1B illustrates an enlarged view of portion 'A' of FIG. 1A.

Referring to FIGS. 1A and 1B, a power semiconductor device 100 may include a substrate 101, a drift layer 102 on the substrate 101, well regions 105 arranged to extend from an upper surface of the drift layer 102, a source region 107 extending from an upper surface of a well region 105 in each of the well regions 105, well contact regions 109 on one side of source regions 107, gate electrodes 130 on the drift layer 102, gate insulating layers 120 between the gate electrodes 130 and the well region 105, isolation insulating layers 110 disposed in isolation trenches IT below the gate electrodes 130, dielectric layers 140 covering the gate electrodes 130, a source electrode 150 on the dielectric layers 140, and a drain electrode 160 on a lower surface of the substrate 101.

The substrate 101 may have an upper surface extending in X and Y-directions (e.g. horizontal directions/a horizontal plane). The substrate 101 may include a semiconductor material, and may include, for example, silicon carbide (SiC). SiC may have various polymorphic crystal forms. For example, SiC may be classified into 3C-SiC, 4H-SiC, 6H-SiC, 15R-SiC, or the like, depending on a polymorphic crystal form, and may be caused by a difference in stacking cycles in a specific crystal direction, such as a (0001) direction in the hexagonal system. The leading number of the above names indicates a number of stacking cycles thereof. For example, 3C-SiC may be a structure in which three layers repeat periodically in a single unit, 4H-SiC may be a structure in which four layers repeat periodically in a single unit, and 6H-SiC may be a structure in which six layers repeat periodically in a single unit. The next English letter represents a crystal axis system, wherein C means a cubic system, H means a hexagonal system, and R means a rhombohedral system. In some implementations, the substrate 101 may include 4H-SiC. In some implementations, the substrate 101 may include a group IV semiconductor material such as Si or Ge, or a compound semiconductor material such as SiGe, GaAs, InAs, or InP.

The substrate 101 may be provided as a bulk wafer or an epitaxial layer. The substrate 101 may include first conductivity-type impurities, and thus may have a first conductivity-type. For example, the first conductivity-type may be an N-type, and the first conductivity-type impurities may be N-type impurities such as nitrogen (N) and/or phosphorus (P). Hereinafter, unless otherwise stated, the description will be based on a case in which the power semiconductor device 100 includes an N-type MOSFET. The power semiconductor device 100 may include a P-type MOSFET in which the first conductivity-type is a P-type.

The drift layer 102 may be disposed on the substrate 101. The drift layer 102 may include a semiconductor material, and may include, for example, SiC. The drift layer 102 may be an epitaxial layer grown on the substrate 101. The drift layer 102 may include first conductivity-type impurities, and thus may have a first conductivity-type. A concentration of the first conductivity-type impurities in the drift layer 102 may be lower than a concentration of the first conductivity-type impurities in the substrate 101. In implementations, the first conductivity-type impurities in the substrate 101 and the first conductivity-type impurities in the drift layer 102 may be the same as or different from each other.

The well regions 105 may be arranged at a predetermined depth from the upper surface of the drift layer 102 and may be arranged to be spaced apart from each other in a horizontal direction, for example, the X-direction. The well region 105 may include a semiconductor material, and may include, for example, SiC. The well region 105 may be a region having a second conductivity-type and may include second conductivity-type impurities. For example, the second conductivity-type may be P-type, and the second conductivity-type impurities may be P-type impurities such as aluminum (Al). In some implementations, the well region 105 may include a plurality of regions having different doping concentrations.

The source regions 107 may be respectively disposed in the well regions 105 and may be disposed at a predetermined depth from the upper surface of the well region 105. Two source regions 107 may be disposed in each well region 105. A thickness of the source region 107 may be smaller than a thickness of the well region 105. The source region 107 may include a semiconductor material, and may include, for example, SiC. The source region 107 may be a region having the first conductivity-type and may include the first conductivity-type impurities described above. A concentration of the first conductivity-type impurities in the source region 107 may be higher than a concentration of first conductivity-type impurities in the drift layer 102, but the present disclosure is not limited thereto.

The well contact regions 109 may be disposed on the well regions 105 and between adjacent source regions 107. The well contact region 109 may be disposed between the well region 105 and the source electrode 150, to allow a voltage from the source electrode 150 to be applied to the well region 105. The well contact region 109 may include a semiconductor material, and may include, for example, SiC. The well contact region 109 may be a region having the second conductivity-type and may include the second conductivity-type impurities described above. A concentration of the second conductivity-type impurities in the well contact region 109 may be higher than a concentration of the second conductivity-type impurities in the well region 105.

The isolation insulating layers 110 may be disposed in the isolation trenches IT extending from the upper surface of the drift layer 102 to a predetermined depth into the drift layer 102 between the well regions 105 (e.g. between adjacent well regions 105). The isolation insulating layer 110 may be disposed to overlap the gate electrode 130 in a vertical direction, for example, the Z-direction. The vertical direction may be perpendicular to the upper surface of the substrate 101 (e.g. perpendicular to the X and Y directions). The isolation insulating layer 110 may be in contact with a first insulating layer 122 through side and lower surfaces of the isolation insulating layer 110 and may be in contact with a second insulating layer 124 through an upper surface of the isolation insulating layer 110. The isolation insulating layer 110 may be located at a depth overlapping the well region 105. For example, at least a portion of the isolation insulating layer 110 may overlap the well region 105 in a horizontal direction. In the present implementation, a level of the lower surface of the isolation insulating layer 110 may be higher than a level of the lower surface of the well region 105. In implementations, the level of the lower surface of the isolation insulating layer 110 may be changed in various manners. The upper surface of the isolation insulating layer 110 may be located on a higher level than an upper surface of the source region 107 but may be changed in various implementations. In some of the claims, the isolation insulating layer 110 may also be referred to as an isolation layer.

The isolation insulating layer 110 may include an insulating material. For example, the isolation insulating layer 110 may include a material having compressive stress, and tensile stress may be applied to at least a portion of the well region 105. This will be described in more detail below with reference to FIG. 1B. The isolation insulating layer 110 may include, for example, silicon nitride (Si₃N₄) having compressive stress. When describing materials "having" compressive or tensile stress, this may refer to a material that is under stress when formed within the semiconductor device. This material may apply stress (e.g. compressive or tensile stress) to other parts of the semiconductor device. This stress may be formed due to characteristics of the material (e.g. lattice mismatch relative to one or more other materials in the semiconductor device, such as one or more adjoining materials). For instance, lattice stress (or lattice strain) can be induced within the semiconductor device. In addition, this stress can be affected by process conditions during manufacture (e.g. temperature and/or pressure).

The gate electrodes 130 may be disposed on the drift layer 102 and may be disposed on end portions of the source regions 107 and on the well regions 105 outside the source regions 107. The gate electrode 130 may be disposed to overlap a portion of the source region 107 and a portion of the well region 105 in a vertical direction, for example, the Z-direction. The gate electrode 130 may be spaced apart from the source region 107, the well region 105, and the drift layer 102 by the gate insulating layer 120.

The gate electrode 130 may include a conductive material, for example, a semiconductor material such as doped polycrystalline silicon, a metal nitride such as titanium nitride (TiN), tantalum nitride (TaN), or tungsten nitride (WN), and/or a metal material such as aluminum (Al), tungsten (W), molybdenum (Mo), or the like. Depending on implementations, the gate electrode 130 may be composed of two or more multiple layers.

The gate insulating layers 120 may be disposed on a lower surface of the gate electrode 130. The gate insulating layer 120 may extend onto the source region 107, the well region 105 outside the source region 107, and the drift layer 102. The gate insulating layer 120 may be disposed between the source region 107 and the gate electrode 130, between the well region 105 and the gate electrode 130, and between the drift layer 102 and the gate electrode 130.

The gate insulating layer 120 may include a first insulating layer 122 and a second insulating layer 124, sequentially stacked from the drift layer 102. The first insulating layer 122 may extend from the drift layer 102 onto a sidewall and a bottom surface of the isolation trench IT. The second insulating layer 124 may not extend into the isolation trench IT but may extend horizontally onto the first insulating layer 122 and the isolation insulating layer 110. In some implementations, the first insulating layer 122 may not extend into the isolation trench IT but may cover the upper surface of the isolation insulating layer 110 and may extend parallel to the second insulating layer 124. A thickness of the second insulating layer 124 may be equal to or greater than a thickness of the first insulating layer 122. Relative thicknesses of the first insulating layer 122 and the second insulating layer 124 may be changed in various implementations.

The first insulating layer 122 and the second insulating layer 124 may include different materials. The first insulating layer 122 and the second insulating layer 124 may include an oxide, a nitride, or a high-κ material. The high-κ material may mean a dielectric material having a higher dielectric constant than silicon oxide (SiO₂). The high-κ material may be, for example, any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃).

At least one of the first insulating layer 122 or the second insulating layer 124, for example, the second insulating layer 124, may include a material having tensile stress, and the tensile stress may be applied in at least a portion of the well region 105. This will be described in more detail below with reference to FIG. 1B. For example, the second insulating layer 124 may include silicon nitride (Si₃N₄) having tensile stress. In some implementations, the first insulating layer 122, instead of the second insulating layer 124, may include a material having tensile stress.

The dielectric layers 140 may cover the gate electrodes 130 and a portion of the source regions 107 and may be disposed to expose a portion of each of the source regions 107. The dielectric layer 140 may cover a side surface of the gate electrode 130 and a side surface of the gate insulating layer 120. The dielectric layer 140 may include a material having tensile stress, similar to the second insulating layer 124, and may apply the tensile stress to at least a portion of the well region 105. For example, the dielectric layer 140 may include silicon nitride (Si₃N₄) having tensile stress. For example, the dielectric layer 140 may include the same material as the second insulating layer 124.

Referring to FIG. 1B, when the power semiconductor device 100 operates, a channel region CR of a transistor may be formed in an upper portion of the well region 105 between the source region 107 and the drift layer 102. The channel region CR may be a partial region of the well region 105 and may be a region not vertically overlapping the source region 107, but vertically overlapping the gate electrode 130.

At least one of the gate insulating layer 120, the isolation insulating layer 110, or the dielectric layer 140 is configured to apply tensile stress to at least a portion of the well region 105. In the present implementation, since the second insulating layer 124 and the dielectric layer 140 have tensile stress, the tensile stress may be applied to the channel region CR, as indicated by corresponding arrows in FIG. 1B. Since the isolation insulating layer 110 has compressive stress, tensile stress may be applied to the channel region CR, as indicated by a corresponding arrow in FIG. 1B. The isolation insulating layer 110, the second insulating layer 124, and the dielectric layer 140 may collectively apply tensile stress to the channel region CR. For example, the isolation insulating layer 110, the second insulating layer 124, and the dielectric layer 140 may include silicon nitride, and may have the same or different types of stress. The silicon nitride may have a composition of Si₃N₄, or a composition different from Si₃N₄. Therefore, the well region 105 may be subjected to tensile stress at least in a region corresponding to the channel region CR.

When the channel region CR is strained by receiving tensile stress, a mobility of a carrier, for example, an electron, in the channel region CR may be improved. The channel region CR may include, for example, a strained SiC region. In a SiC MOSFET, it may be difficult to form a stable gate insulating layer due to carbon (C), as compared to a Si MOSFET, and the mobility of the channel region may be low, since an interface trap density and a near interface trap density may be high. The power semiconductor device 100 of implementations may improve mobility by applying tensile stress to the channel region CR, while securing voltage resistance characteristics based on SiC. Therefore, electrical characteristics such as improvement of switching speed or the like may be improved.

The source electrode 150 may be disposed on the dielectric layers 140 and may be electrically connected to the source regions 107 and the well contact regions 109. The source electrode 150 may include a metal-semiconductor compound layer 152 and a conductive layer 154. The metal-semiconductor compound layer 152 may include a metal element and a semiconductor element, and may include, for example, at least one of TiSi, CoSi, MoSi, LaSi, NiSi, TaSi, or Wsi. The conductive layer 154 may include a metal material, for example, at least one of nickel (Ni), aluminum (Al), titanium (Ti), silver (Ag), vanadium (V), tungsten (W), cobalt (Co), molybdenum (Mo), copper (Cu), or ruthenium (Ru).

The drain electrode 160 may be disposed on the lower surface of the substrate 101 and may be electrically connected to the substrate 101. The drain electrode 160 may include a metal material, for example, at least one of nickel (Ni), aluminum (Al), titanium (Ti), silver (Ag), vanadium (V), or tungsten (W). In some implementations, the drain electrode 160 may also include a metal-semiconductor compound layer and a conductive layer, similar to the source electrode 150.

In description of the following implementations, descriptions repeating those elements described above with reference to FIGS. 1A and 1B will be omitted.

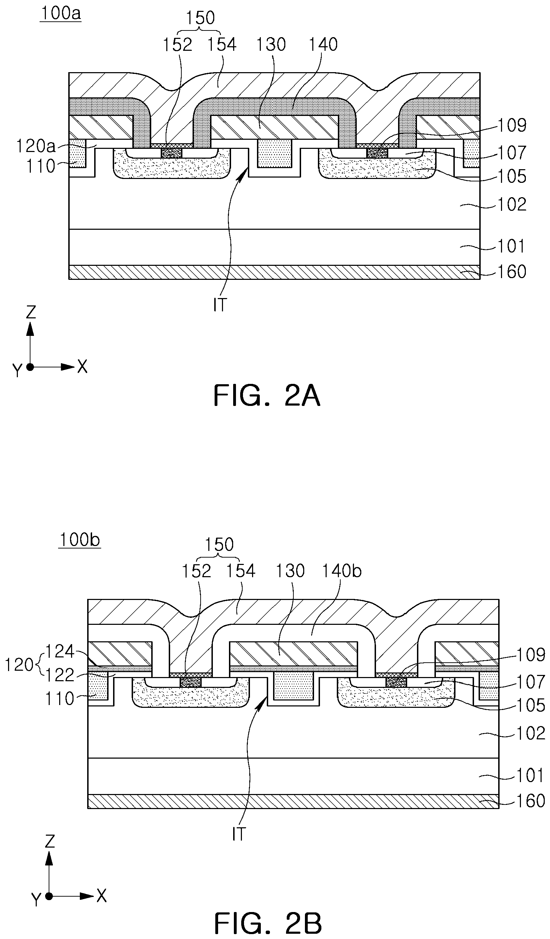

FIGS. 2A to 2E are cross-sectional views illustrating example power semiconductor devices. FIGS. 2A to 2E illustrate regions corresponding to the cross-section in FIG. 1A, respectively.

Referring to FIG. 2A, in a power semiconductor device 100a, a gate insulating layer 120a may be formed as a single layer, and, for example, may not include the second insulating layer 124 of FIG. 1A. The gate insulating layer 120a may not include a material applying tensile stress to a channel region CR (see FIG. 1B). Even in this case, the channel region CR may receive tensile stress due to an isolation insulating layer 110 and a dielectric layer 140.

Referring to FIG. 2B, in a power semiconductor device 100b, a dielectric layer 140b may not include a material applying tensile stress to a channel region CR (see FIG. 1B). The dielectric layer 140b may include, for example, silicon oxide or silicon oxynitride. Even in this case, the channel region CR may receive tensile stress due to an isolation insulating layer 110 and a second insulating layer 124.

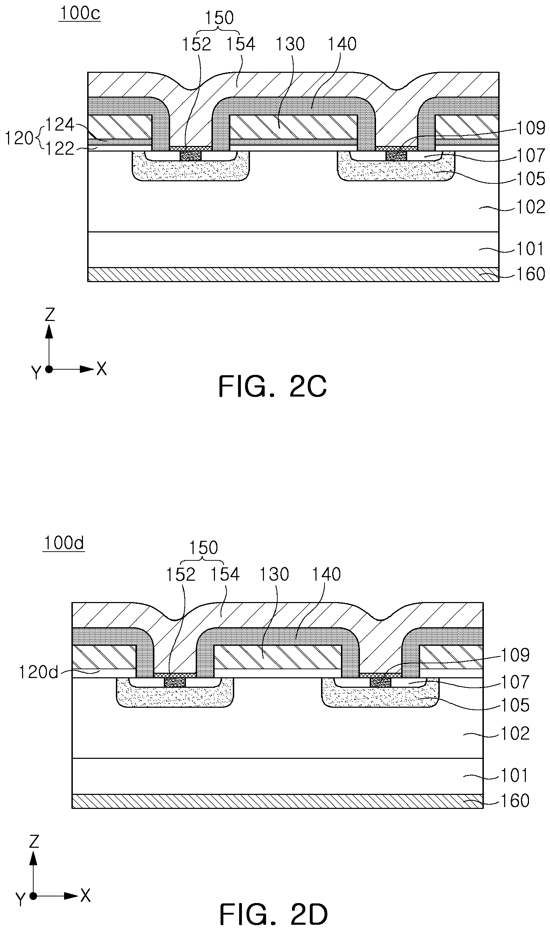

Referring to FIG. 2C, a power semiconductor device 100c may not include the isolation trenches IT and the isolation insulating layer 110 of FIG. 1A. Therefore, a gate insulating layer 120 may extend horizontally onto an upper surface of a drift layer 102. Even in this case, a channel region CR may receive tensile stress due to a dielectric layer 140 and a second insulating layer 124. In some implementations, the dielectric layer 140 may not include a material applying tensile stress to the channel region CR.

Referring to FIG. 2D, a power semiconductor device 100d may not include the isolation trenches IT and the isolation insulating layer 110 of FIG. 1A, and a gate insulating layer 120d may be formed as a single layer. The gate insulating layer 120d may not include a material applying tensile stress to a channel region CR (see FIG. 1B). Even in this case, the channel region CR may receive tensile stress due to a dielectric layer 140.

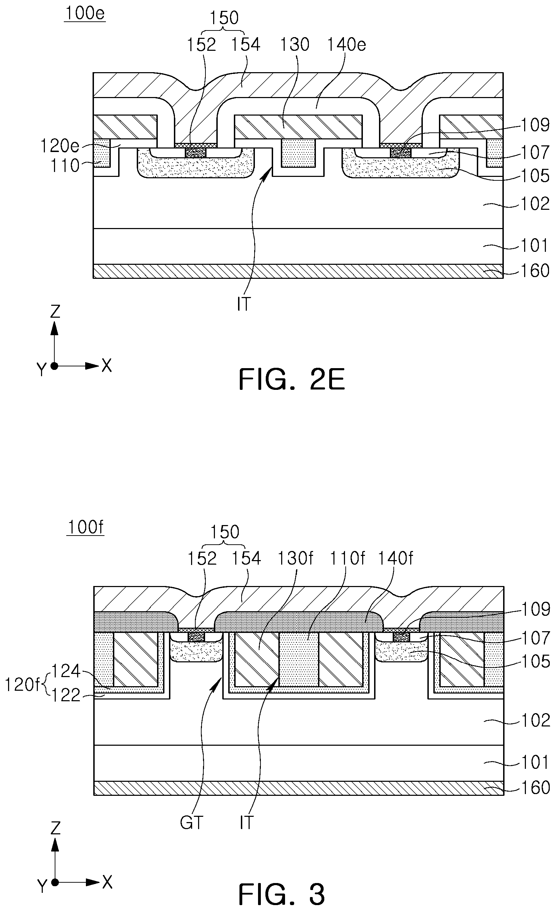

Referring to FIG. 2E, in a power semiconductor device 100e, a gate insulating layer 120e and a dielectric layer 140e may not include a material applying tensile stress to a channel region CR (see FIG. 1B). The gate insulating layer 120e may not include the second insulating layer 124 of FIG. 1A and may be formed as a single layer. Even in this case, the channel region CR may receive tensile stress due to an isolation insulating layer 110.

FIG. 3 is a cross-sectional view illustrating an example power semiconductor device.

Referring to FIG. 3, in a power semiconductor device 100f, gate electrodes 130f may be disposed in a gate trench GT, unlike the implementations of FIGS. 1A to 2E and may be separated from an adjacent gate electrode 130f by an isolation insulating layer 1 10f.

The gate trench GT may be a region extending from an upper surface of a drift layer 102 into the drift layer 102. A gate insulating layer 120f and gate electrodes 130f (e.g. two gate electrodes 130f) may be disposed in the gate trench GT, and an isolation insulating layer 110f may be further disposed in an isolation trench IT passing through the gate electrodes 130f (e.g. between the gate electrodes 130f).

The gate insulating layer 120f may be disposed on a sidewall and a bottom surface of the gate trench GT. An upper surface of the gate electrode 130f may be substantially coplanar with an upper surface of a source region 107. A lower surface of the gate electrode 130f may be located at a lower level than a lower surface of a well region 105. Upper and lower surfaces of the gate electrode 130f may be coplanar with upper and lower surfaces of the isolation insulating layer 110f, respectively. Among side surfaces of each gate electrode 130f, a first side surface facing the adjacent source region 107 may be in contact with a second insulating layer 124, and a second side surface opposite to the first side may be in contact with the isolation insulating layer 1 10f.

The isolation insulating layer 110f may be disposed between the gate electrodes 130f and on one side of each gate electrode 130f. The isolation insulating layer 110f may be located at a depth overlapping the well region 105, and at least a portion thereof may overlap the well region 105 in a horizontal direction, for example, the X-direction. A dielectric layer 140f may cover the gate trench GT and may be in contact with the gate insulating layer 120f, the gate electrode 130f, and the isolation insulating layer 110f.

The well region 105, the source region 107, and a well contact region 109 may be disposed in the drift layer 102 between horizontally adjacent gate trenches GT. In the well region 105, a channel region of a transistor may be formed in regions adjacent to both side surfaces facing the gate electrodes 130f and the gate insulating layer 120f therebetween. In the power semiconductor device 100f, the channel region may be formed along a side surface of the well region 105 in a vertical direction, e.g., the Z-direction, unlike in the implementation of FIG. 1B.

In the present implementation, the isolation insulating layer 1 10f and the second insulating layer 124 may have compressive stress. As a result, tensile stress may be applied to the channel region. The dielectric layer 140f may have tensile stress, and tensile stress may be applied to the channel region. The isolation insulating layer 110f, the second insulating layer 124, and the dielectric layer 140f may commonly apply tensile stress to the channel region. For example, the isolation insulating layer 1 10f, the second insulating layer 124, and the dielectric layer 140f may include the same silicon nitride and may have the same stress or different stresses. Therefore, the well region 105 in a region corresponding to the channel region may receive tensile stress and, for example, may include a strained SiC region. Therefore, electrical characteristics such as improvement of switching speed, or the like, of the power semiconductor device 100f may be improved.

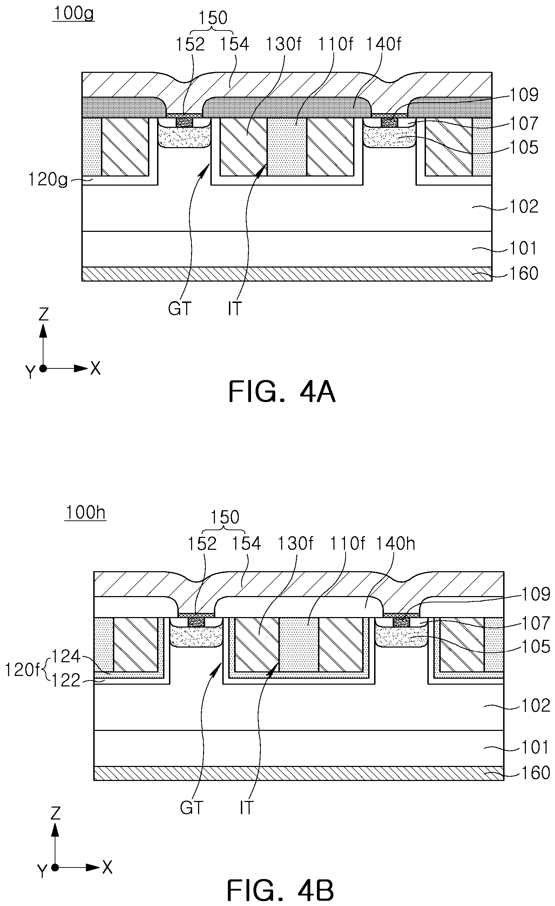

FIGS. 4A to 4E are cross-sectional views illustrating example power semiconductor devices. FIGS. 4A to 4E illustrate regions corresponding to the cross-section in FIG. 3, respectively.

Referring to FIG. 4A, in a power semiconductor device 100g, a gate insulating layer 120g may be formed as a single layer, and, for example, may not include the second insulating layer 124 of FIG. 3. The gate insulating layer 120g may not include a material applying tensile stress to a channel region of a well region 105. Even in this case, the channel region may receive tensile stress due to an isolation insulating layer 110f and a dielectric layer 140f.

Referring to FIG. 4B, in a power semiconductor device 100h, a dielectric layer 140h may not include a material applying tensile stress to a channel region of a well region 105. The dielectric layer 140h may include, for example, silicon oxide or silicon oxynitride. Even in this case, the channel region may receive tensile stress due to an isolation insulating layer 110f and a second insulating layer 124.

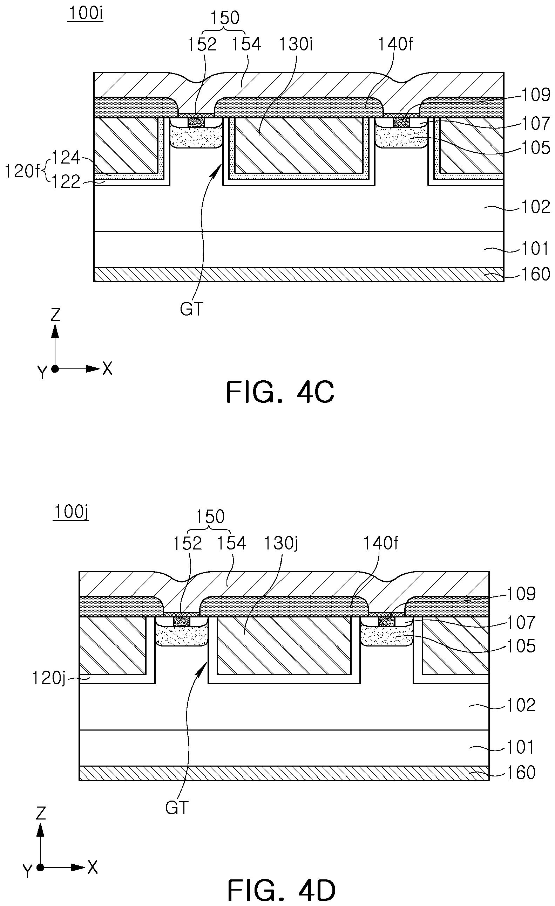

Referring to FIG. 4C, a power semiconductor device 100i may not include the isolation trenches IT and the isolation insulating layer 110f of FIG. 3. Therefore, the gate electrode 130i may be disposed as a single layer in each gate trench GT. Even in this case, a channel region of a well region 105 may receive tensile stress due to a dielectric layer 140f and a second insulating layer 124. In some implementations, the dielectric layer 140f may not include a material applying tensile stress to the channel region.

Referring to FIG. 4D, a power semiconductor device 100j may not include the isolation trenches IT and the isolation insulating layer 110f of FIG. 3, and a gate insulating layer 120j may be formed as a single layer. The gate insulating layer 120j may not include a material applying tensile stress to a channel region of a well region 105. Even in this case, the channel region may receive tensile stress due to a dielectric layer 140f.

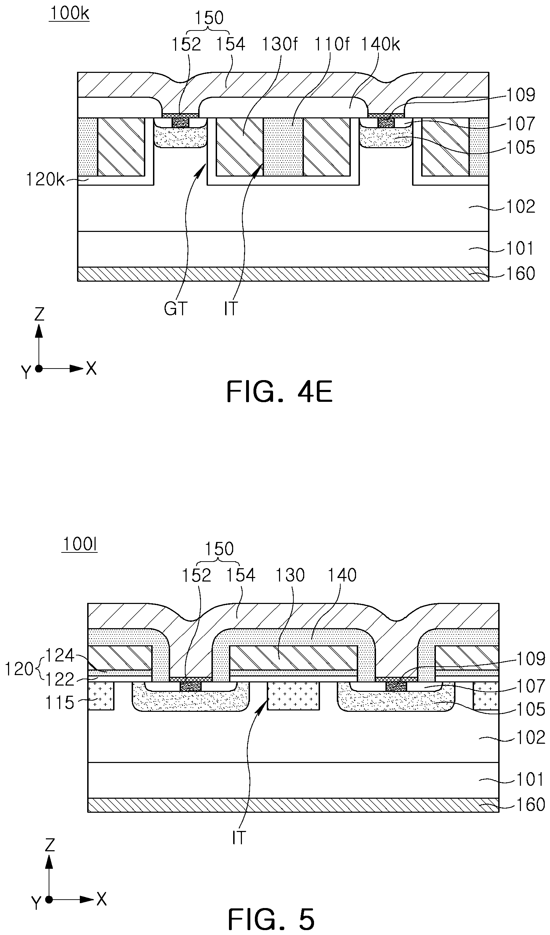

Referring to FIG. 4E, in a power semiconductor device 100k, a gate insulating layer 120k and a dielectric layer 140k may not include a material applying tensile stress to a channel region of a well region 105. The gate insulating layer 120k may not include the second insulating layer 124 of FIG. 3 and may be formed as a single layer. Even in this case, the channel region may receive tensile stress due to an isolation insulating layer 110f.

FIG. 5 is a cross-sectional view illustrating an example power semiconductor device.

Referring to FIG. 5, a power semiconductor device 100l may include a stress semiconductor layer 115 disposed in an isolation trench IT, unlike the implementations of FIGS. 1A to 2E.

Unlike the isolation insulating layer 110 of FIG. 1A, the stress semiconductor layer 115 may include a semiconductor material, and may include, for example, SiC. The stress semiconductor layer 115 may include a material applying stress to a channel region CR, as described above with reference to FIG. 1B. The stress semiconductor layer 115 may include SiC, identical to that of a drift layer 102, but may include a material having a crystal structure different from that of the drift layer 102 and may thus include a material having a lattice constant different from that of the drift layer 102. The stress semiconductor layer 115 may also be referred to as an isolation layer.

In an example implementation, the power semiconductor device 1001 may include, for example, a P-type MOSFET. In this case, a lattice constant of the stress semiconductor layer 115 may be greater a lattice constant of the drift layer 102. For example, the drift layer 102 may include 4H-SiC, and the stress semiconductor layer 115 may include 3C-SiC. In this case, the stress semiconductor layer 115 may have tensile stress, and may apply compressive stress to the channel region CR. A substrate 101, a drift layer 102, and a source region 107 may have a second conductivity-type, and a well region 105 and a well contact region 109 may have a first conductivity-type. For example, the first conductivity-type may be an N-type, and the second conductivity-type may be a P-type. A second insulating layer 124 and a dielectric layer 140 may have compressive stress, and may apply compressive stress to the channel region CR.

In the present implementation, a gate insulating layer 120 may have a shape entirely extending horizontally onto an upper surface of the drift layer 102 and an upper surface of the stress semiconductor layer 115. In some implementations, a first insulating layer 122 may be disposed to extend into the isolation trench IT, as illustrated in FIG. 1A.

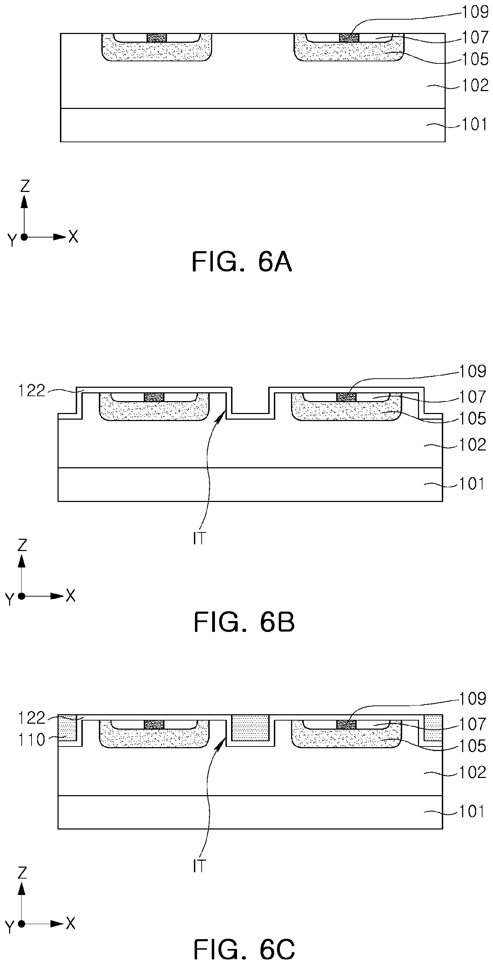

FIGS. 6A to 6F are views illustrating a process sequence illustrating an example method of manufacturing a power semiconductor device. FIGS. 6A to 6F illustrate an example of a method of manufacturing the power semiconductor device of FIG. 1A.

Referring to FIG. 6A, a drift layer 102 may be formed on a substrate 101, and well regions 105, source regions 107, and well contact regions 109 may be formed.

The substrate 101 may be provided as a SiC wafer, for example. The drift layer 102 may be formed by epitaxial growth from the substrate 101. The drift layer 102 may be formed to include first conductivity-type impurities.

The well regions 105, the source regions 107, and the well contact regions 109 may be sequentially formed in the drift layer 102 by an ion implantation process. Second conductivity-type impurities may be implanted into the well regions 105 and the well contact regions 109, and first conductivity-type impurities may be implanted into the source regions 107. After the ion implantation process, an annealing process may be performed at a high temperature, for example, about 1600°C to about 1800°C (e.g. between 1600°C and 1800°C).

Referring to FIG. 6B, isolation trenches IT may be formed, and a first insulating layer 122 may be formed.

The isolation trenches IT may be formed between the well regions 105 by partially removing the drift layer 102 from an upper surface. The isolation trenches IT may be formed deeper than the source regions 107 and may be formed to have the same or similar depth as the well regions 105. In implementations, a depth of the isolation trenches IT may be changed.

The first insulating layer 122 may be formed entirely on an upper surface of a structure to be manufactured, to extend from upper surfaces of the source regions 107 and upper surfaces of the well contact regions 109 into the isolation trenches IT. The first insulating layer 122 may be formed by, for example, an oxidation process, such as a thermal oxidation process. In some implementations, the first insulating layer 122 may be formed by a deposition process.

Referring to FIG. 6C, isolation insulating layers 110 may be formed in the isolation trenches IT.

The isolation insulating layers 110 may be formed by a deposition process and may be formed of a material applying tensile stress to adjacent well regions 105. The isolation insulating layers 110 may be formed of a material having compressive stress. For example, the isolation insulating layers 110 may be formed to have compressive stress by depositing silicon nitride (Si₃N₄) and controlling process conditions such as a process pressure and/or a process temperature.

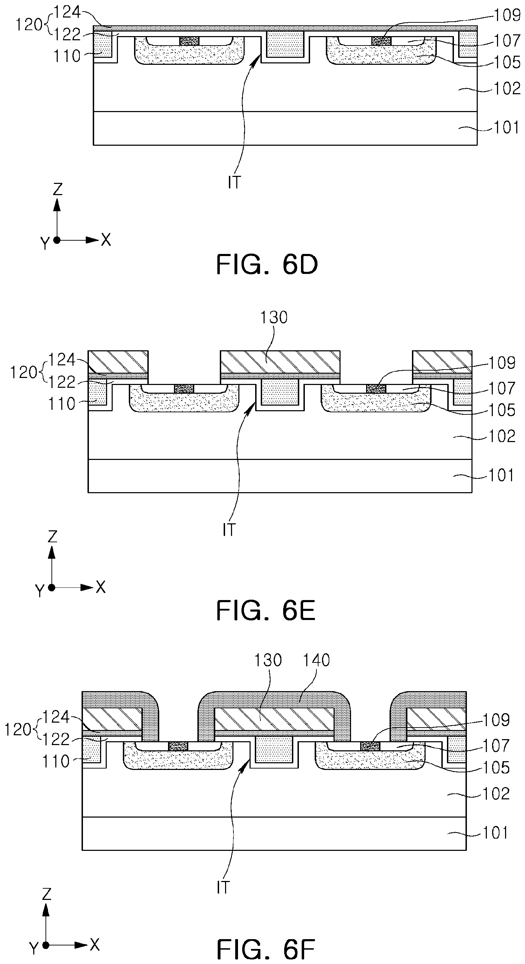

Referring to FIG. 6D, a second insulating layer 124 may be formed on the first insulating layer 122 and the isolation insulating layers 110.

The second insulating layer 124 may be formed on entirely an upper surface of a structure to be manufactured. The second insulating layer 124 may form a gate insulating layer 120, together with the first insulating layer 122. A total thickness of the gate insulating layer 120 may range from about 400 Å to 600 Å (e.g. from 400 Å to 600 Å). The second insulating layer 124 may be half or more the total thickness of the gate insulating layer 120, but the present disclosure is not limited thereto.

The second insulating layer 124 may be formed by a deposition process and may be formed of a material applying tensile stress to the well regions 105 outside the source regions 107. The second insulating layer 124 may be formed of a material having tensile stress. For example, the second insulating layer 124 may be formed to have tensile stress by depositing silicon nitride (Si₃N₄) and controlling process conditions such as a process pressure and/or a process temperature.

Referring to FIG. 6E, gate electrodes 130 may be formed on the gate insulating layers 120.

The gate electrodes 130 may be formed, for example, by depositing doped polycrystalline silicon. The gate electrodes 130 may be patterned, together with each of the gate insulating layers 120, to expose a portion of the source regions 107 and the well contact regions 109.

Referring to FIG. 6F, dielectric layers 140 covering the gate electrodes 130 may be formed.

The dielectric layers 140 may be deposited entirely on an upper surface of a structure to be manufactured and may be then partially removed by an etching process, to expose a portion of each of the source regions 107. The dielectric layer 140 may be formed to cover upper and side surfaces of the gate electrode 130, a side surface of the gate insulating layer 120, and a portion of an upper surface of the source region 107.

The dielectric layers 140 may be formed of a material applying tensile stress to the well regions 105 outside the source regions 107 and may be formed of a material having tensile stress. For example, the dielectric layers 140 may be formed of the same material and by the same process as the second insulating layer 124. The dielectric layers 140 may be formed to have tensile stress by depositing silicon nitride (Si₃N₄) and controlling process conditions such as a process pressure and/or a process temperature.

Next, referring to FIG. 1A together, a source electrode 150 may be formed on the dielectric layers 140, the source regions 107, and the well contact regions 109, and a drain electrode 160 may be formed on a lower surface of the substrate 101.

First, metal-semiconductor compound layers 152 may be formed at an interface with the source regions 107 and the well contact regions 109, and a conductive layer 154 covering the metal-semiconductor compound layers 152 and the dielectric layers 140 may be formed to prepare the source electrode 150.

Next, the drain electrode 160 may be formed by depositing a metal material on the lower surface of the substrate 101. In some implementations, the drain electrode 160 may be formed by another process operation. As a result, the power semiconductor device 100 of FIG. 1A may be manufactured.

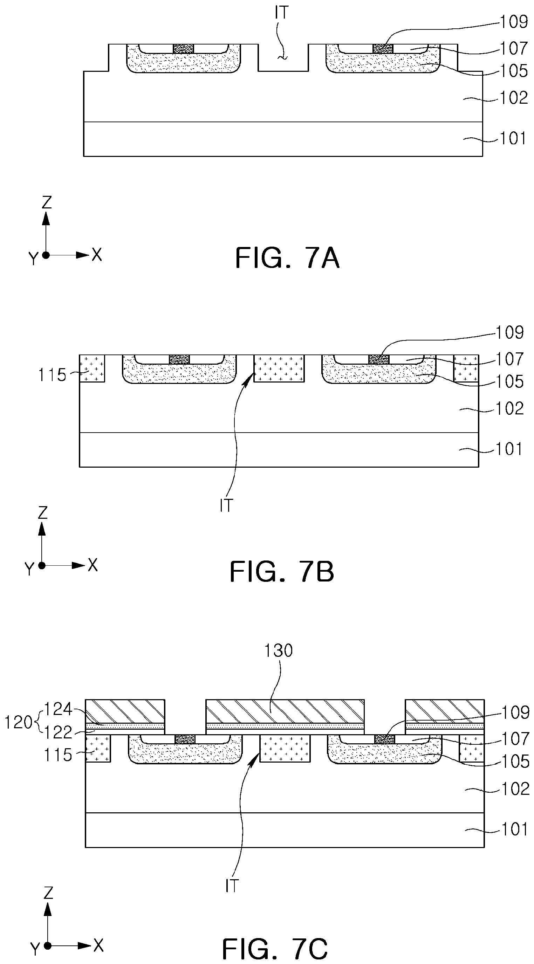

FIGS. 7A to 7C are views illustrating a process sequence illustrating an example method of manufacturing a power semiconductor device. FIGS. 7A to 7C illustrate an implementation of a method of manufacturing the power semiconductor device of FIG. 5.

Referring to FIG. 7A, a drift layer 102 may be formed on a substrate 101, well regions 105, source regions 107, and well contact regions 109 may be formed, and isolation trenches IT may be formed.

The contents described above with reference to FIGS. 6A and 6B may be equally applied to the above processes.

Referring to FIG. 7B, stress semiconductor layers 115 may be formed in the isolation trenches IT.

The stress semiconductor layers 115 may be formed by epitaxial growth from the drift layer 102, and may be formed of a material applying stress, for example, compressive stress, to the well regions 105 outside the source regions 107. The stress semiconductor layers 115 may be formed of a material having tensile stress. For example, the stress semiconductor layers 115 may be formed of a material having a lattice constant, different from that of the drift layer 102 to have tensile stress.

Referring to FIG. 7C, gate insulating layers 120 and gate electrodes 130 may be formed.

The gate insulating layers 120 may be formed by sequentially forming a first insulating layer 122 and a second insulating layer 124 entirely over an upper surface of a structure to be manufactured and patterning them together with the gate electrodes 130 formed on an upper portion. The second insulating layer 124 may be formed of a material applying compressive stress to the well regions 105 outside the source regions 107. The second insulating layer 124 may be formed of a material applying stress, different from that of the stress semiconductor layers 115, for example, compressive stress. For example, the second insulating layer 124 may be formed to have compressive stress by depositing silicon nitride (Si₃N₄) and controlling process conditions such as a process pressure and/or a process temperature.

Next, referring to FIG. 5, dielectric layers 140 covering the gate electrodes 130 may be formed, and a source electrode 150 and a drain electrode 160 may be formed.

The dielectric layers 140 may be formed as described above with reference to FIG. 6F. The dielectric layers 140 may be formed of a material applying compressive stress to the well regions 105 outside the source regions 107 and may be formed of a material having compressive stress. For example, the dielectric layers 140 may be formed of the same material and through the same process as the second insulating layer 124. The dielectric layers 140 may be formed to have compressive stress by depositing silicon nitride (Si₃N₄) and controlling process conditions such as a process pressure and/or a process temperature.

Next, the power semiconductor device 1001 of FIG. 5 may be manufactured by forming the source electrode 150 and the drain electrode 160.

A power semiconductor device having improved electrical characteristics may be provided by optimizing arrangement of layers applying stress to a channel region.

Various advantages and effects of the present disclosure are not limited to the above-described content and can be more easily understood through description of specific implementations.

Embodiments are set out in the following clauses:
Clause 1. A power semiconductor device comprising:
   a substrate of a first conductivity-type;
   a drift layer of the first conductivity-type on the substrate;
   a well region of a second conductivity-type extending from an upper surface of the drift layer into the drift layer;
   a source region of the first conductivity-type extending from an upper surface of the well region into the well region;
   a gate electrode at least partially on the drift layer;
   an isolation insulating layer on one side of the gate electrode at a depth at least partially overlapping the well region;
   a dielectric layer covering the gate electrode and at least partially exposing the source region; and
   a drain electrode on a lower surface of the substrate,
   wherein at least one of the isolation insulating layer or the dielectric layer includes a material applying tensile stress to at least a portion of the well region.
Clause 2. The power semiconductor device of Clause 1, wherein the isolation insulating layer is in a trench extending from the upper surface of the drift layer, below the gate electrode.
Clause 3. The power semiconductor device of Clause 1 or Clause 2, wherein the gate electrode has a first side surface adjacent to the source region and a second side surface opposite to the first side surface,
   wherein the isolation insulating layer is in contact with the second side surface.
Clause 4. The power semiconductor device of any preceding Clause, wherein the gate electrode and the isolation insulating layer are in a gate trench extending from the upper surface of the drift layer.
Clause 5. The power semiconductor device of any preceding Clause, wherein the isolation insulating layer and the dielectric layer comprise materials having different types of stress.
Clause 6. A power semiconductor device comprising:
   a substrate of a first conductivity-type;
   a drift layer of the first conductivity-type on the substrate;
   a well region of a second conductivity-type extending from an upper surface of the drift layer into the drift layer;
   a source region of the first conductivity-type extending from an upper surface of the well region into the well region;
   a gate electrode at least partially on the drift layer;
   a gate insulating layer below the gate electrode;
   an isolation layer in an isolation trench extending from the upper surface of the drift layer into the drift layer below the gate electrode;
   a dielectric layer covering the gate electrode and partially exposing the source region; and
   a drain electrode on a lower surface of the substrate,
   wherein at least one of the isolation layer or the dielectric layer includes a first material applying stress to at least a portion of the well region.
Clause 7. The power semiconductor device of Clause 6, wherein the well region comprises a strained silicon carbide region.
Clause 8. The power semiconductor device of Clause 7, wherein the gate insulating layer comprises a second material applying stress to at least the portion of the well region.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While example embodiments have been illustrated and described above, it will be apparent to those skilled in the art that modifications and variations could be made without departing from the scope of the present disclosure as defined by the appended claims.

## Claims

1. A power semiconductor device comprising:
a substrate of a first conductivity-type;
a drift layer of the first conductivity-type on the substrate;
a well region of a second conductivity-type extending from an upper surface of the drift layer into the drift layer;
a source region of the first conductivity-type extending from an upper surface of the well region into the well region;
a gate electrode at least partially on the drift layer and the well region;
a gate insulating layer between the gate electrode and the well region;
an isolation insulating layer in an isolation trench extending from the upper surface of the drift layer into the drift layer below the gate electrode;
a dielectric layer covering the gate electrode and at least partially covering the source region; and
a drain electrode on a lower surface of the substrate,
wherein at least one of the gate insulating layer, the isolation insulating layer, or the dielectric layer is configured to apply tensile stress to at least a portion of the well region.

2. The power semiconductor device of claim 1, wherein the gate insulating layer, the isolation insulating layer, and the dielectric layer are configured to apply tensile stress to at least the portion of the well region.

3. The power semiconductor device of claim 2, wherein the gate insulating layer and the dielectric layer comprise a first material having tensile stress, and
the isolation insulating layer comprises a second material having compressive stress.

4. The power semiconductor device of claim 2 or claim 3, wherein the gate insulating layer, the isolation insulating layer, and the dielectric layer comprise silicon nitride.

5. The power semiconductor device of any preceding claim, wherein the gate insulating layer comprises a first insulating layer on the well region and a second insulating layer on the first insulating layer,
wherein the second insulating layer is configured to apply tensile stress to at least the portion of the well region.

6. The power semiconductor device of claim 5, wherein the first insulating layer extends from the upper surface of the well region along the upper surface of the drift layer, a sidewall of the isolation trench, and a bottom surface of the isolation trench, and
the second insulating layer extends onto an upper surface of the first insulating layer and an upper surface of the isolation insulating layer.

7. The power semiconductor device of claim 5 or claim 6, wherein the isolation insulating layer contacts the first insulating layer through a lower surface and a side surface of the isolation insulating layer, and contacts the second insulating layer through an upper surface of the isolation insulating layer.

8. The power semiconductor device of any preceding claim, wherein:
at least the portion of the well region comprises a region not vertically overlapping the source region but vertically overlapping the gate electrode; and/or
an upper surface of the isolation insulating layer is located at a higher level than an upper surface of the source region; and/or
the dielectric layer covers a side surface of the gate electrode and a side surface of the gate insulating layer.

9. The power semiconductor device of any preceding claim, further comprising a source electrode on the dielectric layer, the source electrode being connected to the source region.

10. The power semiconductor device of any preceding claim, wherein the substrate, the drift layer, and the well region comprise silicon carbide.

11. The power semiconductor device of any preceding claim, wherein the first conductivity-type is N-type, and the second conductivity-type is P-type.

12. The power semiconductor device of any preceding claim, wherein at least one of the isolation insulating layer or the dielectric layer is configured to apply tensile stress to at least the portion of the well region.

13. The power semiconductor device of any preceding claim, wherein the well region comprises a strained silicon carbide region.

14. A power semiconductor device comprising:
a substrate of a first conductivity-type;
a drift layer of the first conductivity-type on the substrate;
a well region of a second conductivity-type extending from an upper surface of the drift layer into the drift layer;
a source region of the first conductivity-type extending from an upper surface of the well region into the well region;
a gate electrode at least partially on the drift layer;
an isolation insulating layer on one side of the gate electrode at a depth at least partially overlapping the well region;
a dielectric layer covering the gate electrode and at least partially exposing the source region; and
a drain electrode on a lower surface of the substrate,
wherein at least one of the isolation insulating layer or the dielectric layer includes a material applying tensile stress to at least a portion of the well region.

15. A power semiconductor device comprising:
a substrate of a first conductivity-type;
a drift layer of the first conductivity-type on the substrate;
a well region of a second conductivity-type extending from an upper surface of the drift layer into the drift layer;
a source region of the first conductivity-type extending from an upper surface of the well region into the well region;
a gate electrode at least partially on the drift layer;
a gate insulating layer below the gate electrode;
an isolation layer in an isolation trench extending from the upper surface of the drift layer into the drift layer below the gate electrode;
a dielectric layer covering the gate electrode and partially exposing the source region; and
a drain electrode on a lower surface of the substrate,
wherein at least one of the isolation layer or the dielectric layer includes a first material applying stress to at least a portion of the well region.
